# EUROPEAN PATENT APPLICATION

(11) **EP 2 023 660 A1**
(43) Date of publication of application: **11.02.2009**
(21) Application number: 07743644.2
(22) Date of filing: 18.05.2007
(51) Int. Cl.: H04R 23/02, H02N 2/00, H04R 1/24, H04R 9/06, H04R 15/00

(54) **HYBRID ACTUATOR, LOUDSPEAKER AND SOUND OUTPUT METHOD**

(30) Priority: 29.05.2006 JP 2006147701
(71) Applicant: Sony Corporation, Tokyo 108-0075 (JP)
(72) Inventor: SUZUKI, Nobukazu, Tokyo 108-0075 (JP); URYU, Masaru, Tokyo 108-0075 (JP); OHASHI, Yoshio, Tokyo 108-0075 (JP)
(74) Representative: Körber, Martin Hans
(86) International application number: PCT/JP2007/060209
(87) International publication number: WO 2007/138886

(57) **Abstract**

A hybrid actuator (100A) includes a magnetostrictive actuator (110) having a magnetostrictive element (111), and a moving-coil actuator (130) including a movable portion (132) having an outer periphery to which voice coils (131a), (131b) are attached. The actuator (110) is fixed to the movable portion (132) of the actuator (130) so that the direction of displacement output of a drive rod (113) becomes the same as the displacement direction of this movable portion. Since the actuator (110) is fixed to the movable portion (132) of the actuator (130), together with a displacement output in response to a high-frequency-range audio signal, which is obtained by the actuator (110), a displacement output in response to a low-frequency-range audio signal, which is obtained by the actuator (130), is also obtained at a tip of the drive rod (113). By abutting the tip of the drive rod (113) against an acoustic diaphragm, a wide band audio output can be obtained.

## Description

### Technical Field

The present invention relates to a hybrid actuator, a speaker apparatus, and an audio output method for applying a vibration to, for example, an acoustic diaphragm on the basis of an audio signal to obtain an audio output. Specifically, the present invention relates to a hybrid actuator etc., in which a hybrid structure is provided in which a magnetostrictive actuator unit having a displacement transmitting unit that outputs a displacement caused by expansion and contraction of a magnetostrictive element is fixed to a movable portion of a moving-coil actuator so that the direction of displacement output of the displacement transmitting unit becomes the same as the displacement direction of the movable portion, whereby a wide band audio output can be satisfactorily obtained.

### Background Art

Hitherto, as described in, for example, Patent Document 1, a speaker apparatus in which a diaphragm is driven using a magnetostrictive actuator to obtain an audio output has been known. A magnetostrictive actuator is an actuator that uses a magnetostrictive element whose shape changes in response to the application of an external magnetic field. In recent years, as magnetostrictive elements, super-magnetostrictive elements whose shape changes by an amount up to about 1000 times that of previously existing ones have appeared. Due to the large stress generated, magnetostrictive actuators have a benefit that a relatively large audio output can be obtained, even if they are small in size, depending on an acoustic diaphragm to be caused to vibrate.

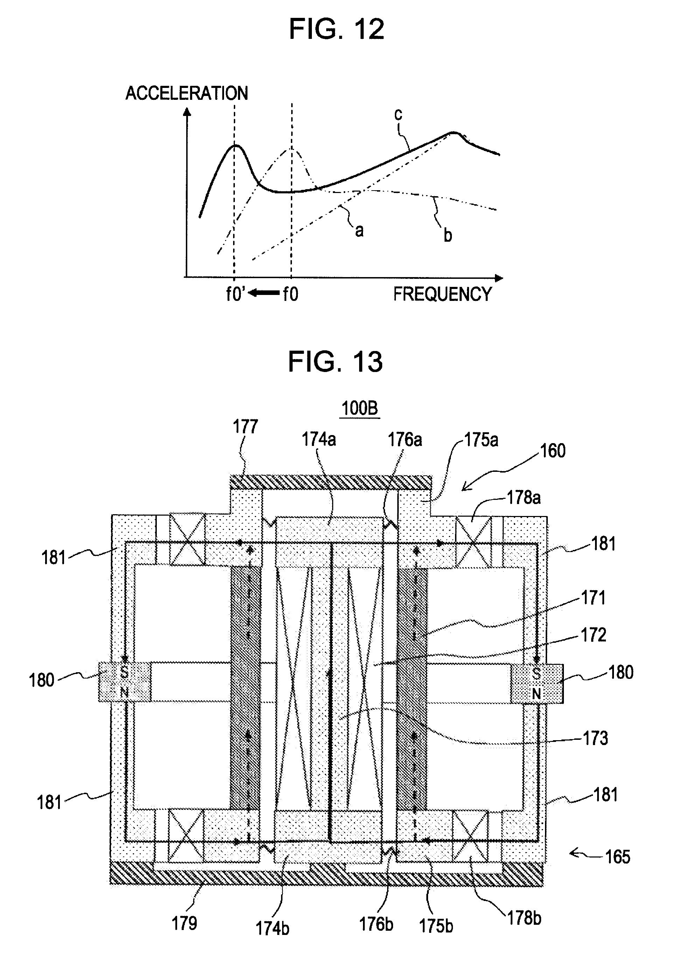

This magnetostrictive actuator undergoes a change in size due to a change in the magnetic field, and responds to displacement output to generate a driving force. Here, a sound pressure is considered in a case where an audio signal is handled. Note that, here, since sound pressure is proportional to acceleration, an acceleration output response of a magnetostrictive actuator is considered. The acceleration output response of the magnetostrictive actuator exhibits, as shown by a curve a of Fig. 12, an ever-increasing characteristic. In the magnetostrictive actuator, therefore, there are disadvantages in that the sound pressure is low in a low-frequency range and distortion involved in the low-frequency range is also relatively large.

Hitherto, as described in, for example, Patent Document 2, in order to overcome the disadvantages of the magnetostrictive actuator, a speaker apparatus having a hybrid structure including the magnetostrictive actuator and a moving-coil actuator has been contemplated.
Patent Document 1: Japanese Unexamined Patent Application Publication No. 04-313999
Patent Document 2: Japanese Unexamined Patent Application Publication No. 2004-363967

### Disclosure of Invention

### Technical Problem

In the speaker apparatus described in Patent Document 2 described above, a magnetic flux path in a magnetic circuit of the magnetostrictive actuator and a magnetic flux path in a magnetic circuit of the moving-coil actuator are not separated from each other. Thus, the magnetic flux path in the magnetic circuit of the moving-coil actuator has inserted therein a magnetostrictive element having a magnetic permeability as low as about 8, and even if this moving-coil actuator is driven by a low-frequency-range audio signal, a displacement output corresponding to the low-frequency-range audio signal is not sufficiently obtained, resulting in a weak audio output in a low frequency range.

It is an object of the present invention to provide the capability of satisfactorily obtaining a wide band audio output.

### Technical Solution

A concept of the present invention resides in a hybrid actuator characterized by including:
a magnetostrictive actuator unit including a magnetostrictive element, a first magnetic circuit that has a magnet and that applies a magnetic bias to the magnetostrictive element, and a magnetic field generating coil that generates a magnetic field in an expansion and contraction direction of the magnetostrictive element, and also including a displacement transmitting unit that outputs a displacement caused by expansion and contraction of the magnetostrictive element; and
a moving-coil actuator including a movable portion to which voice coils are attached, and a second magnetic circuit that has a magnet and that generates interlinked magnetic fluxes in the voice coils,
wherein the magnetostrictive actuator unit is fixed to the movable portion of the moving-coil actuator so that a direction of displacement output of the displacement
transmitting unit becomes the same as a displacement direction of the movable portion.

In the present invention, a magnetostrictive actuator unit includes a magnetostrictive element. A magnetic bias is supplied to this magnetostrictive element by a first magnetic circuit having a magnet. In this case, the magnetostrictive element is inserted in a magnetic flux path in the first magnetic circuit. The application of magnetic bias allows the magnetostrictive element to be expanded to some extent in advance, and enables not only expansion but also contraction in a magnetic field generated by a magnetic field generating coil.

A magnetic field is generated in an expansion and contraction direction of the magnetostrictive element by the magnetic field generating coil. By causing a current in response to an audio signal in, for example, a high-frequency range (first frequency band) to flow in this magnetic field generating coil, the magnetostrictive element is expanded and contracted according to the high-frequency-range audio signal. A displacement caused by expansion and contraction of the magnetostrictive element is output from the displacement transmitting unit. In this case, the displacement caused by expansion and contraction of the magnetostrictive element is transferred to the displacement transmitting unit directly or after it is magnified by a displacement magnifying device.

Furthermore, the moving-coil actuator includes a movable portion to which voice coils are attached. Interlinked magnetic fluxes are generated in these voice coils by a second magnetic circuit having a magnet. By causing a current based on an audio signal in, for example, a low-frequency range (second frequency band that is on a side lower than the first frequency band, a portion of which may overlap the first frequency band) to flow in the voice coils, the movable portion is displaced in an axial direction by the Lorentz force.

The magnetostrictive actuator unit described above is fixed to the movable portion so that a direction of displacement output of the displacement transmitting unit becomes the same as a displacement direction of this movable portion. Thus, the displacement of the movable portion in the axial direction is also transmitted to the displacement transmitting unit of the magnetostrictive actuator unit described above. Therefore, from the displacement transmitting unit, a displacement output caused by expansion and contraction of the magnetostrictive element (for example, a displacement output in response to a high-frequency-range audio signal) is obtained and, in addition, a displacement output corresponding to the displacement of the movable portion of the moving-coil actuator (for example, a displacement output in response to a low-frequency-range audio signal) is also obtained in such a manner as to be superimposed thereon.

The displacement transmitting unit of the magnetostrictive actuator unit described above is directly or indirectly abutted against an acoustic diaphragm to construct a speaker apparatus. As an acoustic diaphragm, for example, a planar diaphragm or a tubular diaphragm is used. In a case where a planar diaphragm is used, the displacement transmitting unit described above is abutted against a surface of the planar diaphragm.

Further, in a case where a tubular diaphragm is used, the displacement transmitting unit described above is abutted against an end surface of the tubular diaphragm. In this case, since the acoustic diaphragm is excited by the actuator to vibrate with a vibration component in a surface direction (a direction parallel to the surface), an elastic wave based on the audio signal propagates along the acoustic diaphragm in the surface direction. Then, as this elastic wave propagates along the acoustic diaphragm, a mode conversion from a longitudinal wave to a transverse wave to a longitudinal wave ... is repeated to generate a combined longitudinal-transverse wave. Vibrations in a surface-normal direction (a direction vertical with respect to the surface) of the acoustic diaphragm is excited by the transverse waves, and an acoustic wave is radiated to the outside from the surface of the acoustic diaphragm, whereby an audio output is obtained.

The acoustic diaphragm is excited to vibrate with a vibration component in its surface direction. Thus, a large transverse wave is not generated at a vibration excitation point, and an acoustic wave radiated from this vibration excitation point is not perceived as a significantly large sound compared with acoustic waves radiated from other positions, which facilitates the localization of sound across the entirety of the acoustic diaphragm. An expanding sound image can be obtained.

As described above, the displacement output caused by the magnetostrictive actuator unit and the displacement output caused by the moving-coil actuator are obtained so as to be superimposed on each other at the displacement transmitting unit of the magnetostrictive actuator unit in the manner described above. Therefore, the acoustic diaphragm is vibrated by the displacement outputs caused by both actuators, and an audio output is obtained. For example, the magnetostrictive actuator unit is driven by a high-frequency-range audio signal and the moving-coil actuator is driven by a low-frequency-range audio signal, whereby a wide band audio signal is satisfactorily obtained from the acoustic diaphragm. In this case, furthermore, the displacement outputs caused by both actuators are transmitted to the acoustic diaphragm from a single drive point called the displacement transmitting unit of the magnetostrictive actuator unit, and a coherent audio output is obtained.

Note that magnetic flux paths in the first magnetic circuit of the magnetostrictive actuator unit and in the second magnetic circuit of the moving-coil actuator may be partially shared. In this case, the magnetostrictive element is designed to constitute the magnetic flux path of the first magnetic circuit, and a magnetic bias is applied to the magnetostrictive element. The magnetostrictive element, on the other hand, is designed so as not to constitute the magnetic flux path of the second magnetic circuit so that the magnetostrictive element, which is low in magnetic permeability, would not adversely affect the displacement operation of the moving-coil actuator. Accordingly, the partial sharing of the magnetic flux paths enables lightweight and compact design. The partial sharing of the magnetic flux paths further allows a magnet to be shared by the first magnetic circuit and the second magnetic circuit to enable low-cost construction.

### Advantageous Effects

According to the present invention, a hybrid structure is provided in which a magnetostrictive actuator unit including a displacement transmitting unit that outputs a displacement caused by expansion and contraction of a magnetostrictive element is fixed to a movable portion of a moving-coil actuator so that a direction of displacement output of the displacement transmitting unit becomes the same as a displacement direction of the movable portion, and a wide band audio output can satisfactorily be obtained. Brief Description of Drawings

[Fig. 1] Fig. 1 is a cross-sectional view showing a structure of a hybrid actuator as an embodiment.
[Fig. 2] Fig. 2 is a diagram for explaining the operation of the hybrid actuator.
[Fig. 3] Fig. 3 is a diagram showing a structure of a drive system for the hybrid actuator.
[Fig. 4] Fig. 4 is a cross-sectional view showing a structure of a speaker apparatus using the hybrid actuator.
[Fig. 5] Fig. 5 is a cross-sectional view showing a structure of another speaker apparatus using the hybrid actuator.
[Fig. 6] Fig. 6 is a perspective view showing a structure of a different speaker apparatus using the hybrid actuator.
[Fig. 7] Fig. 7 is a longitudinal cross-sectional view showing the structure of the different speaker apparatus using the hybrid actuator.
[Fig. 8] Fig. 8 is a top view showing the structure of the different speaker apparatus using the hybrid actuator.
[Fig. 9] Fig. 9 is a bottom view showing the structure of the different speaker apparatus using the hybrid actuator.
[Fig. 10] Fig. 10 is a diagram showing a state where the hybrid actuator is fixed to a receiving hole.
[Fig. 11] Fig. 11 is a diagram showing a structure of a drive system for four hybrid actuators and a speaker unit.
[Fig. 12] Fig. 12 is a diagram showing, by comparison, frequency characteristics (acceleration response outputs) of a magnetostrictive actuator, a moving-coil actuator, and a hybrid actuator.
[Fig. 13] Fig. 13 is a cross-sectional view showing a structure of a hybrid actuator as another embodiment.
[Fig. 14] Fig. 14 is a cross-sectional view showing a structure of a hybrid actuator as another embodiment. Explanation of Reference Numerals

100A, 100B, 100C hybrid actuator, 110 magnetostrictive actuator, 110A magnetostrictive actuator unit, 111 magnetostrictive element, 112 magnetic field generating coil, 113 drive rod, 114 receiving unit, 115 spring, 116 aluminum housing, 117 fixing board, 118 ring-shaped magnet, 119 tube-shaped yoke, 120 opening, 131a, 131b voice coil, 132 movable portion, 133 ring-shaped magnet, 134 tube-shaped yoke, 135a, 135b damper, 150 CD player, 151 digital signal processor, 152 amplifier, 153, 155 high-pass filter, 154, 157 low-pass filter, 156 band-pass filter, 160 magnetostrictive actuator, 165 moving-coil actuator, 171 magnetostrictive element, 172 magnetic field generating coil, 173 pole piece, 174a, 174b circular-plate-shaped yoke, 175a, 175b ring-shaped yoke, 176a, 176b damper, 177 circular-plate-shaped member, 178a, 178b voice coil, 179 fixing board, 180 ring-shaped magnet, 181 tube-shaped yoke, 190 displacement magnifying device, 190a displacement transmitting unit, 200A to 200C speaker apparatus

### Best Modes for Carrying Out the Invention

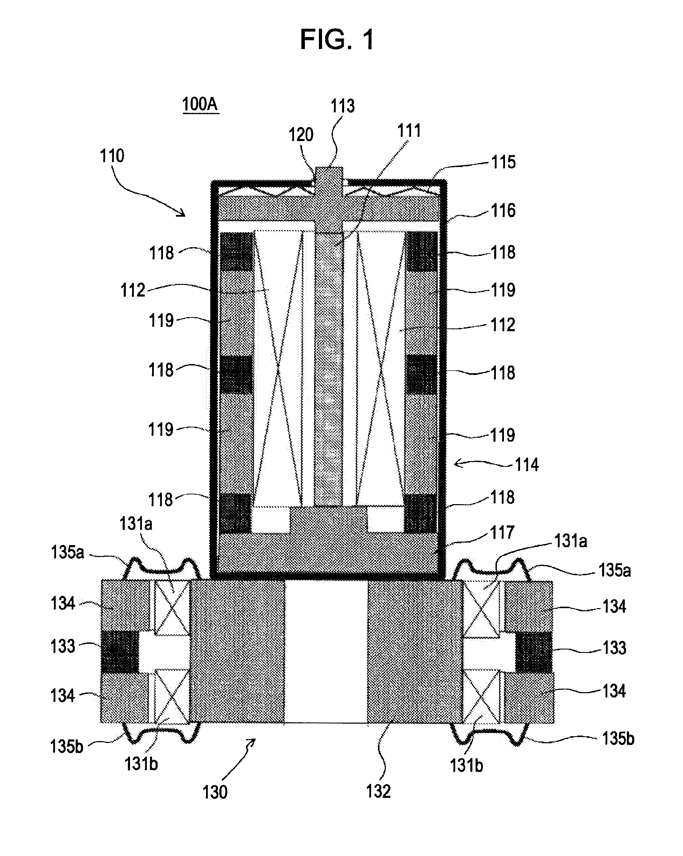

Embodiments of the present invention will be described hereinafter with reference to the drawings. A cross-sectional view shown in Fig. 1 shows a structure of a hybrid actuator 100A as an embodiment. The hybrid actuator 100A includes a magnetostrictive actuator 110 constituting a magnetostrictive actuator unit, and a moving-coil actuator 130.

The magnetostrictive actuator 110 is configured as follows: the magnetostrictive actuator 110 includes a rod-shaped magnetostrictive element 111 that expands and contracts in a longitudinal direction, a magnetic field generating coil (solenoid coil) 112 that generates a magnetic field in the expansion and contraction direction of the magnetostrictive element 111, a drive rod 113 serving as a movable member that is connected to one end of the magnetostrictive element 111 and that transmits a displacement output obtained at this one end, a receiving unit 114 that receives the magnetostrictive element 111 and the magnetic field generating coil 112, a spring 115 that applies a physical bias (dynamic bias) to the magnetostrictive element 111, and an aluminum housing 116 that covers the whole of the magnetostrictive actuator 110. Here, the drive rod 113 constitutes a displacement transmitting unit that outputs a displacement caused by expansion and contraction of the magnetostrictive element 111.

The receiving unit 114 is constituted by a fixing board 117, ring-shaped magnets (permanent magnets) 118, and tube-shaped yokes 119. The other end of the magnetostrictive element 111 is fixed to the fixing board 117, and the magnetostrictive element 111 is supported by the fixing board 117. As described above, the one end of the magnetostrictive element 111 is connected to the drive rod 113. The magnetic field generating coil 112 is also fixed onto the fixing board 117 so as to be located around the magnetostrictive element 111.

Further, three ring-shaped magnets 118 and two tube-shaped yokes 119 are alternately stacked and fixed onto the fixing board 117 so as to be located around the magnetostrictive element 111 and the magnetic field generating coil 112. Here, the fixing board 117, the ring-shaped magnets 118, and the tube-shaped yokes 119 constitute, together with the magnetostrictive element 111 and the drive rod 113, a magnetic circuit (first magnetic circuit).

In this case, the magnetostrictive element 111 is in a state of being inserted in a magnetic flux path in this magnetic circuit. This magnetic circuit is provided in order to apply a magnetic bias (static bias) to the magnetostrictive element 111. The application of magnetic bias allows the magnetostrictive element to be expanded to some extent in advance, and enables not only expansion but also contraction in a magnetic field generated by the magnetic field generating coil 112. The fixing board 117 and the tube-shaped yokes 119, as well as the drive rod 113, are composed of a ferromagnetic material, thereby facilitating the efficient application of magnetic bias to the magnetostrictive element 111.

The aluminum housing 116 has a cylindrical contour, and accommodates therein the magnetostrictive element 111, magnetic field generating coil 112, drive rod 113, and receiving unit 114 (fixing board 117, ring-shaped magnets 118, and tube-shaped yokes 119) described above. A circular opening 120 is disposed at a center of a surface of the aluminum housing 116, which is near the one end of the magnetostrictive element 111 described above. A tip of the drive rod 113 described above is projected to the outside through the opening 120.

The spring 115 is arranged between the surface of the aluminum housing 116 where the opening 120 is disposed and the drive rod 113. The spring 115 applies, as the physical bias (dynamic bias) described above, an urging force having a predetermined magnitude to the magnetostrictive element 111 in a direction extending from the one end side to the other end side. Thereby, the linearity of displacement output of the magnetostrictive element 111 is enhanced.

The magnetostrictive actuator 110 is configured in the manner described above. A current in response to a high-frequency-range audio signal (high-frequency-range component of an audio signal) is caused to flow in the magnetic field generating coil 112 to generate a magnetic field in the expansion and contraction direction of the magnetostrictive element 111, so that the magnetostrictive element 111 is expanded and contracted according the high-frequency-range audio signal and, at the one end thereof, that is, at the tip of the drive rod 113, a displacement output in response to the high-frequency audio signal is obtained.

The moving-coil actuator 130 includes a movable portion 132 having an outer periphery to which voice coils (moving coils) 131a and 131b are attached, and a ring-shaped magnet 133 and tube-shaped yokes 134, which are arranged along the outer periphery of the movable portion 132. The movable portion 132 is formed of a circular-tube-shaped ferromagnetic material having a hollow center portion, for example, iron.

The ring-shaped magnet 133 is designed to be sandwiched between the two tube-shaped yokes 134, and those ring-shaped magnet 133 and two tube-shaped yokes 134 are stacked. Those ring-shaped magnet 133 and tube-shaped yokes 134 constitute, together with the movable portion 132 described above, a magnetic circuit (second magnetic circuit). This magnetic circuit generates interlinked magnetic fluxes in the voice coils 131a and 131b. Like the tube-shaped yokes 119 of the magnetostrictive actuator 110 described above, the tube-shaped yokes 134 are composed of a ferromagnetic material, whereby the interlinked magnetic fluxes can be efficiently generated.

Note that the voice coils 131a and 131b attached to upper and lower ends of the movable member 132 are designed to have opposite winding directions because magnetic flux directions at their respective positions are opposite to each other so that Lorentz forces generated at the voice coils 131a and 131b are caused to be in the same direction.

A damper 135a is installed between an upper outer peripheral portion of the movable portion 132 and an upper surface of the upper tube-shaped yoke 134, and a damper 135b is installed between a lower outer peripheral portion of the movable portion 132 and a lower surface of the lower tube-shaped yoke 134. Thereby, the movable portion 132 is fixed to a fixed portion (a portion in which the ring-shaped magnet 133 and the tube-shaped yokes 134 are stacked) in a displaceable manner.

The moving-coil actuator 130 is configured in the manner described above. A current in response to a low-frequency-range audio signal (low-frequency-range component of the audio signal) is caused to flow in the voice coils 131a and 131b, so that, due to the Lorentz force, the movable portion 132 is displaced in an axial direction (which is the same as the expansion and contraction direction of the magnetostrictive element 111 of the magnetostrictive actuator 110) according to the low-frequency-range audio signal.

The magnetostrictive actuator 110 described above is coaxially fixed to the movable portion 132 of the moving-coil actuator 130. Thereby, the direction of displacement output of the drive rod 113 becomes the same as the displacement direction of the movable portion 132. In this case, for example, the fixing board 117 side of the magnetostrictive actuator 110 is bonded and fixed to the upper surface side of the movable portion 132. Note that the term coaxially as used herein means that the center axis of the magnetostrictive actuator 110 and the center axis of the moving-coil actuator 130 are aligned or substantially aligned with each other.

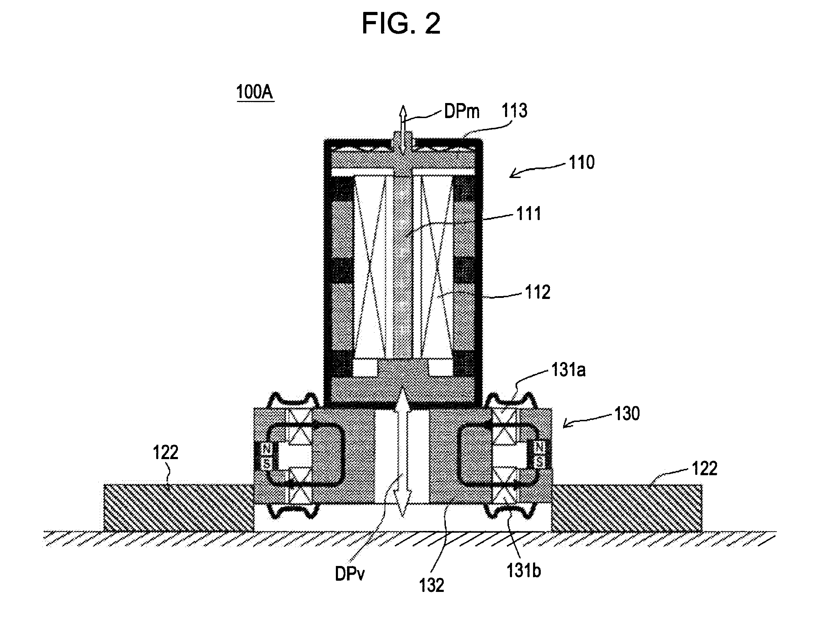

The magnetostrictive actuator 110 is coaxially fixed to the movable portion 132 of the moving-coil actuator 130, whereby the displacement of the movable portion 132 in the axial direction is also transmitted to the magnetostrictive element 111 of the magnetostrictive actuator 110 described above. Therefore, at the one end of the magnetostrictive element 111, that is, at the tip of the drive rod 113, as shown in Fig. 2, a displacement output DPm in response to the high-frequency-range audio signal, which is generated by the above-described magnetostrictive actuator 110 itself, is obtained and, in addition, a displacement output DPv in response to the low-frequency-range audio signal, which is generated by the moving-coil actuator 130, is also obtained in such a manner as to be superimposed thereon.

Note that Fig. 2 shows a state where the fixed portion of the moving-coil actuator 130 (the stacked section made up of the ring-shaped magnet 133 and the tube-shaped yokes 134) is placed on, for example, a table through a fixing plate 122.

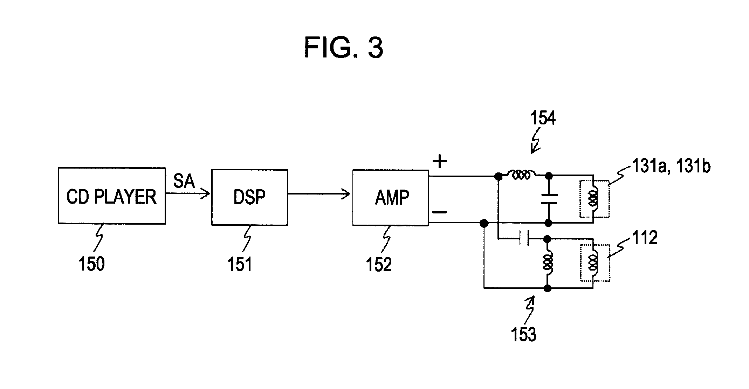

Fig. 3 shows a drive system for the magnetostrictive actuator 110 and moving-coil actuator 130 described above.

An audio signal SA from, for example, a CD (Compact Disc) player 150 serving as a music signal source is supplied to a DSP (Digital Signal Processor) 151, and hybrid actuator correction, that is, correction processing regarding output characteristics of the magnetostrictive actuator 110 and the moving-coil actuator 130, etc., are performed.

The audio signal SA after being subjected to the correction processing by the DSP 151 is amplified by an amplifier 152. Then, in a signal current obtained by the amplification in the amplifier 152, a high-frequency-range component (a component of, for example, 2 kHz to 20 kHz) is extracted by a high-pass filter (HPF) 153 made up of a capacitor and a coil, and is supplied to the magnetic field generating coil 112 of the magnetostrictive actuator 110.

In the signal current obtained by the amplification in the amplifier 152, a low-frequency-range component (a component of, for example, 350 Hz to 2 kHz) is further extracted by a low-pass filter (LPF) 154 made up of a coil and a capacitor, and is supplied to the voice coils 131a and 131b of the moving-coil actuator 130. The high-frequency range and the low-frequency range may partially overlap each other. For example, the high-frequency range is 2 kHz to 20 kHz and the low-frequency range is 350 Hz to 3 kHz, or the like.

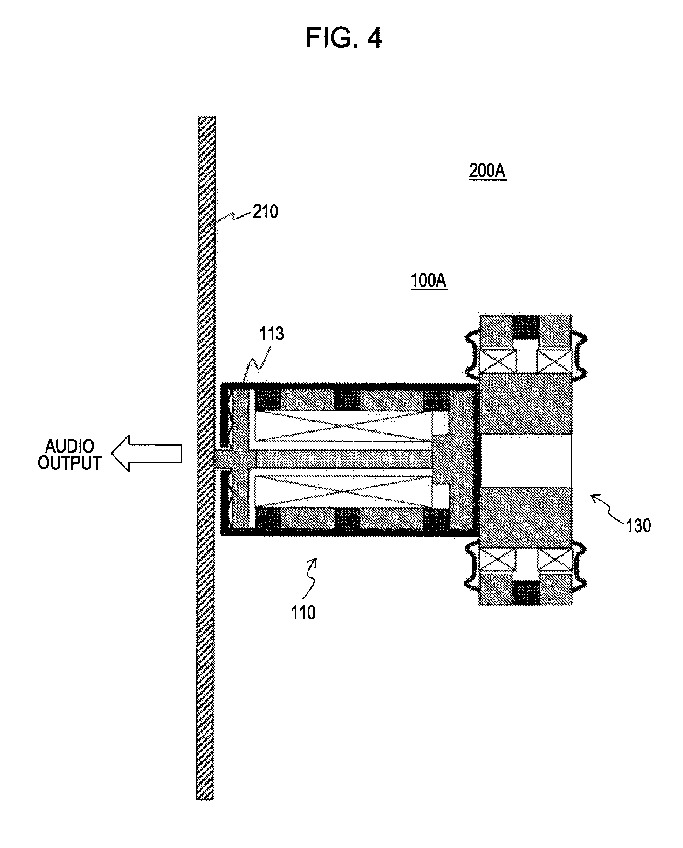

In the drive system shown in Fig. 3, the high-pass filter 153 and the low-pass filter 154 are arranged on the output side of the single amplifier 152 to allow separation into the high-frequency-range component and the low-frequency-range component, which are then supplied to the respective coils. Alternatively, a structure may be provided in which the high-frequency-range component and the low-frequency-range component are separated and output from the DSP 151, and the respective components are amplified by different amplifiers and supplied to the respective coils. Next, a speaker apparatus using the hybrid actuator 100A shown in Fig. 1 will be described. Fig. 4 shows a speaker apparatus 200A using the hybrid actuator 100A. The speaker apparatus 200A uses a planar diaphragm 210 as an acoustic diaphragm.

In the speaker apparatus 200A, the tip of the drive rod 113 of the hybrid actuator 100A is bonded or screwed to a surface of the planar diaphragm 210. In this case, the hybrid actuator 100A excites, by its inertial force, the planar diaphragm 210 to vibrate.

As described above, in a case where the magnetostrictive actuator 110 is driven by a high-frequency-range audio signal and the moving-coil actuator 130 is driven by a low-frequency-range audio signal, the planar diaphragm 210 is vibrated by the displacement output DPm in response to the high-frequency-range audio signal and the displacement output DPv in response to the low-frequency-range audio signal, which are obtained at the tip of the drive rod 113 of the magnetostrictive actuator 110 in the manner described above, and therefore a wide band audio output is obtained from the planar diaphragm 210.

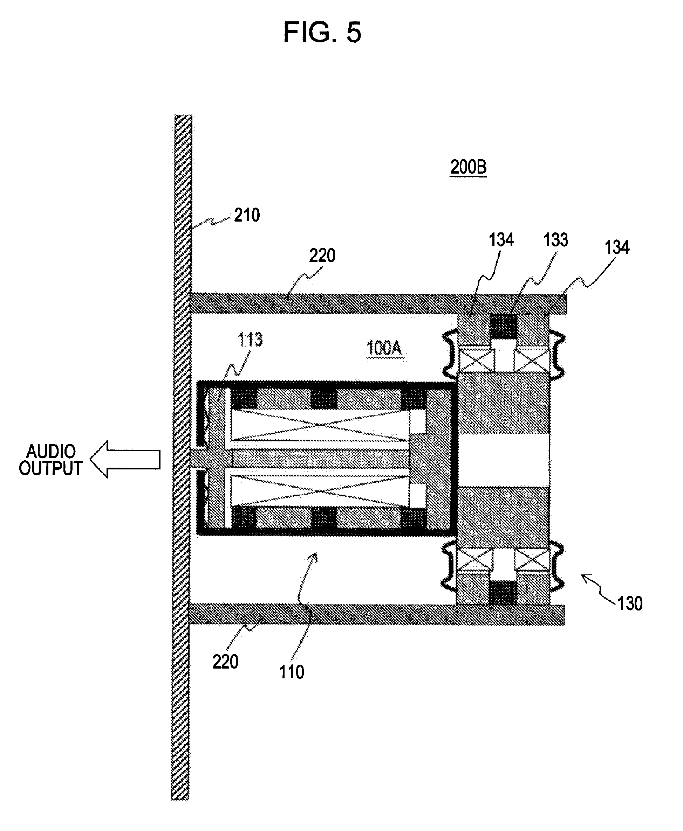

Fig. 5 shows a speaker apparatus 200B using the hybrid actuator 100. Like the speaker apparatus 200A shown in Fig. 4, the speaker apparatus 200B uses a planar diaphragm 210 as an acoustic diaphragm.

In the speaker apparatus 200B, the fixed portion (the stacked portion made up of the ring-shaped magnet 133 and the tube-shaped yokes 134) of the moving-coil actuator 130 is fixed to a surface of the planar diaphragm 210 by using a fixing member 220 in a state where the tip of the drive rod 113 of the hybrid actuator 100A is being brought into abutment against the surface of the planar diaphragm 210. In this case, a displacement of the tip of the drive rod 113 of the magnetostrictive actuator 110, as viewed from the fixed portion of the moving-coil actuator 130, excites the planar diaphragm 210 to vibrate.

In the speaker apparatus 200B, when the magnetostrictive actuator 110 is driven by a high-frequency-range audio signal and the moving-coil actuator 130 is driven by a low-frequency-range audio signal in the manner described above, the planar diaphragm 210 is caused to vibrate by the displacement output DPm in response to the high-frequency-range audio signal and the displacement output DPv in response to the low-frequency-range audio signal, which are obtained at the tip of the drive rod 113 of the magnetostrictive actuator 110 in the manner described above, and therefore a wide band audio output is obtained from the planar diaphragm 210.

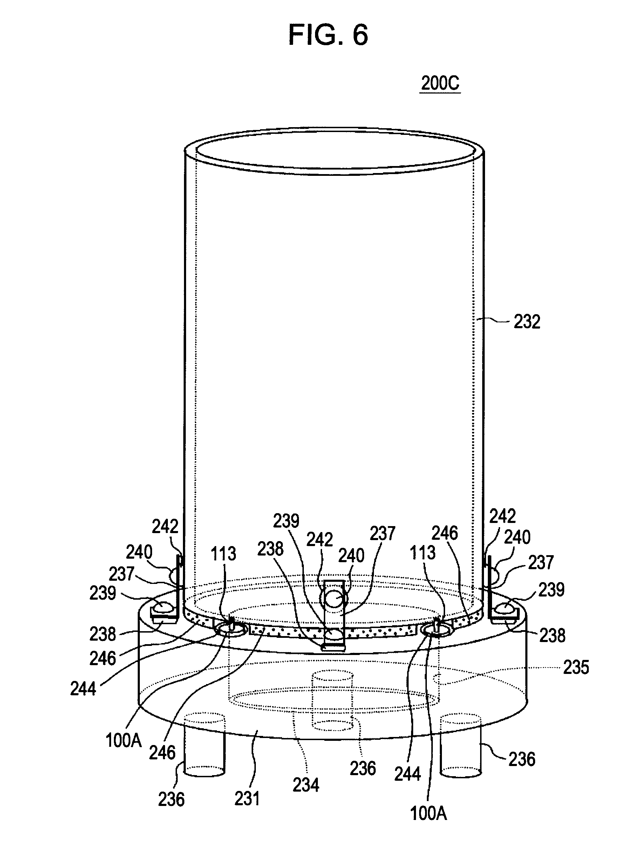

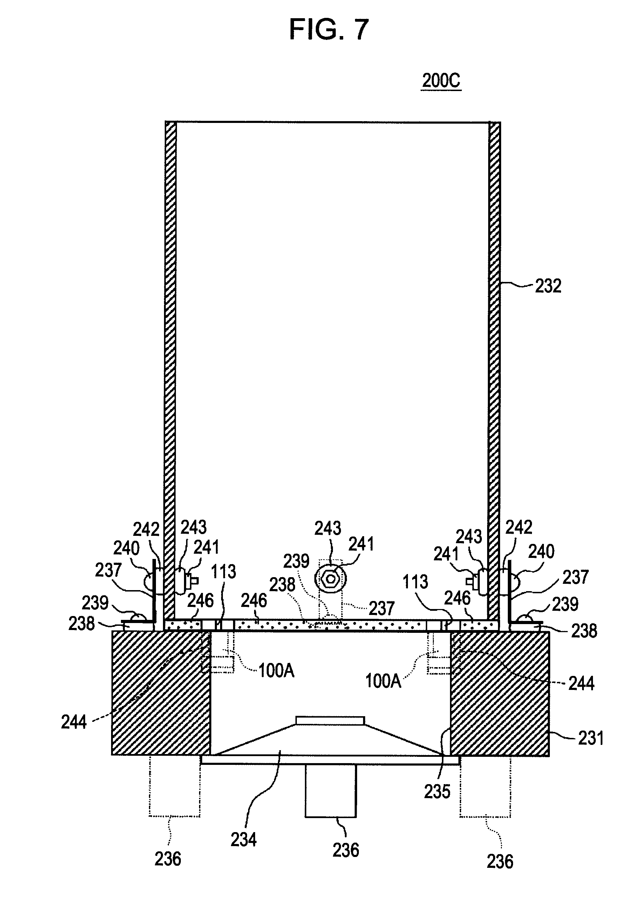

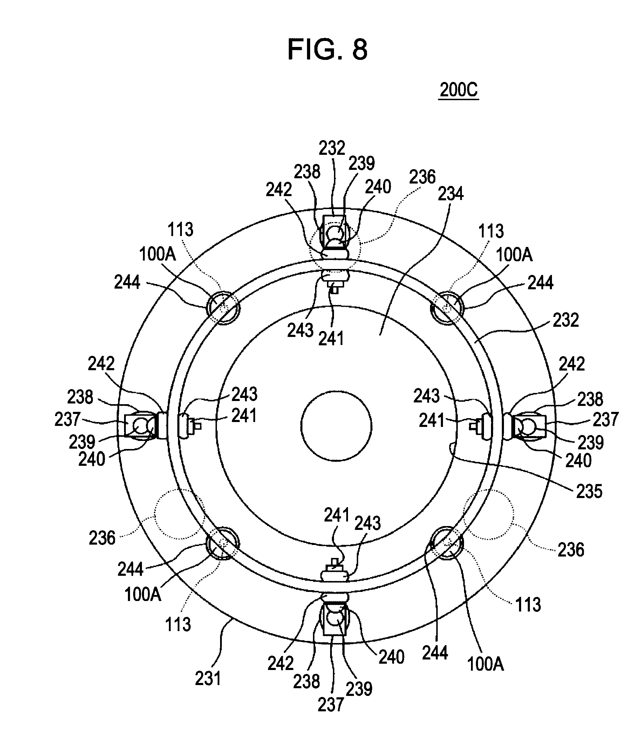

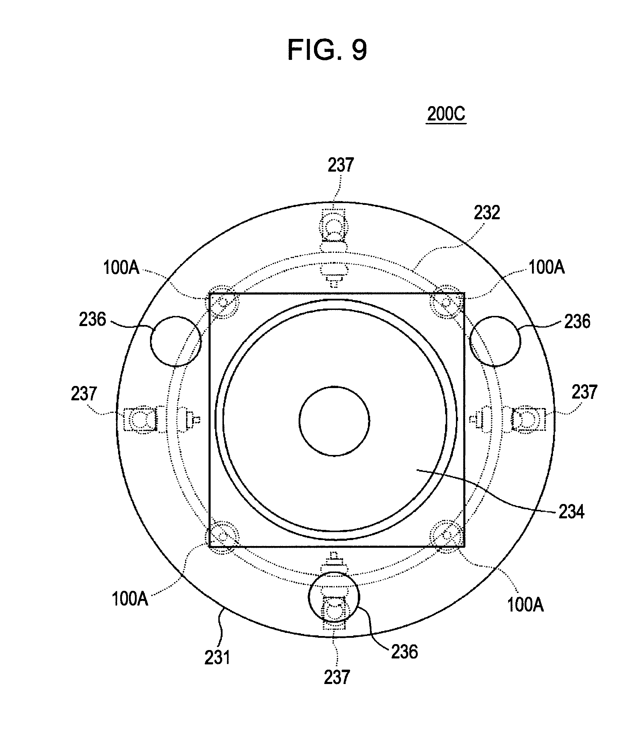

Figs. 6 to 9 show a speaker apparatus 200C using the hybrid actuator 100. The speaker apparatus 200C uses a pipe 230 as an acoustic diaphragm. Fig. 6 is a perspective view of the speaker apparatus 200C, Fig. 7 is a longitudinal cross-sectional view of the speaker apparatus 200C, Fig. 8 is a top view of the speaker apparatus 200C, and Fig. 9 is a bottom view of the speaker apparatus 200C.

The speaker apparatus 200C includes a base housing 231, the pipe 232, hybrid actuators 100A (see Figs. 1 and 2), and a speaker unit 234. The pipe 232 constitutes a tubular diaphragm serving as an acoustic diaphragm.

The base housing 231 is formed of, for example, synthetic resin. The base housing 231 is formed into a circular plate shape as a whole, at a center portion of which a cylindrical through opening portion 235 is disposed. A predetermined number of, in this embodiment, three, leg portions 236 are erected at equal intervals along a lower outer peripheral side of the base housing 231.

If the number of leg portions 236 is three, those three leg portions 236 necessarily come into contact with an installation surface, which enables more stable installation than that in a case where, for example, four leg portions are provided. Furthermore, since the leg portions 236 are disposed on a lower surface of the base housing 231, the lower surface of the base housing 231 can be spaced apart from the installation surface so that an acoustic wave from the speaker unit 234 attached to the lower surface side of the base housing 231 can be radiated to the outside.

The pipe 232 is formed of a predetermined material, for example, a transparent acrylic material. The pipe 232 is fixed to the base housing 231. That is, a lower end portion of the pipe 232 is fixed to an upper surface of the base housing 231 at a plurality of positions, in this embodiment, four positions, using metal L-shaped angles 237. The pipe 232 has sizes of, for example, 1000 mm long, 100 mm diameter, and 2 mm thick, by way of example.

In this case, the L-shaped angles 237 have formed, at one ends and the other ends thereof, circular holes for screwing, which are not shown in the figure. The one ends of the L-shaped angles 237 are screwed to the upper surface of the base housing 231 using screws 239. The base housing 231 has formed therein thread grooves (not shown) that are fitted with screw portions of the screws 239. In this case, ring-shaped damping members 238 composed of a rubber material or the like are interposed between the one ends of the L-shaped angles 237 and the upper surface of the base housing 231.

The other ends of the L-shaped angles 237 are further screwed to the lower end portion of the pipe 232 using screws 240 and nuts 241. The lower end portion of the pipe 232 has formed therein circular holes (not shown) through which screw portions of the screws 240 pass. Ring-shaped damping members 242 and 243 composed of a rubber material or the like are interposed between the other ends of the L-shaped angles 237 and an outer surface of the pipe 232 and between the nuts 241 and an inner surface of the pipe 232, respectively.

In this manner, with the interposition of the damping members 238, 242, and 243, vibrations (elastic waves) caused by the hybrid actuators 100A can be blocked from propagating to the base housing 231 through the pipe 232 and the L-shaped angles 237, and the localization of sound toward the base housing 231 side is prevented.

A plurality of, in the present embodiment, four, hybrid actuators 100A are fixed to the base housing 231. The four hybrid actuators 100A are arranged at equal intervals along a round end surface on the lower end portion side of the pipe 232. In this case, receiving holes 244 for receiving the hybrid actuators 100A are formed in the base housing 231. The hybrid actuators 100A are received in the receiving holes 244 and are thus fixed to the base housing 231.

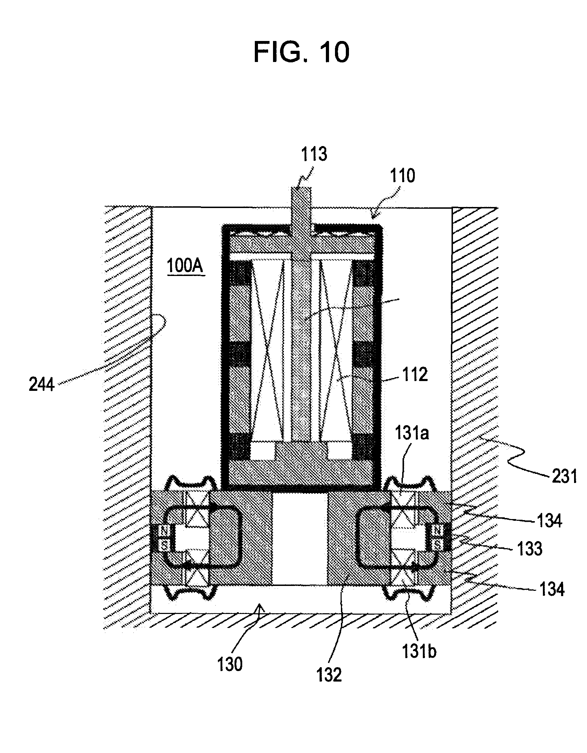

Fig. 10 shows a fixing of each of the hybrid actuators 100A. The hybrid actuator 100A is such that, for example, the fixed portion (the stacked portion made up of the ring-shaped magnet 133 and the tube-shaped yokes 134) of the moving-coil actuator 130 is bonded and fixed to an inner wall of a corresponding one of the receiving holes 244. This ensures that the movable portion 132 of the moving-coil actuator 130 can be displaced in the axial direction.

In a state where the hybrid actuators 100A are fixedly received in the receiving holes 244 of the base housing 231, the tips of the drive rods 113 of the hybrid actuators 100A come into abutment against the end surface on the lower end portion side of the pipe 232. In this case, the displacement direction of the drive rods 113 is set to a direction perpendicular to this end surface, that is, the axial direction of the pipe 232. This axial direction is also a surface direction (a direction parallel to the surface) of the pipe 232. With this arrangement, the hybrid actuators 100A can excite the pipe 232 to vibrate with, from the end surface on the lower end portion side of the pipe 232, a vibration component in the direction perpendicular to this end surface.

The pipe 232 and the hybrid actuators 100A constitute a speaker responsible for middle- and high-frequency-range sides of an audio frequency band and function as a tweeter. The speaker unit 234, on the other hand, constitutes a speaker responsible for a low-frequency-range side of the audio frequency band and functions as a woofer.

The speaker unit 234 is attached at a position corresponding to the opening portion 235 on the lower surface side of the base housing 231 using, for example, screws (not shown) in such a manner that a front side of the speaker unit 234 is directed downward.

In this case, the speaker unit 234 is in a state of being arranged so as to be coaxial with the pipe 232. An acoustic wave of positive phase, which is output from the front side of the speaker unit 234, is radiated to the outside from the lower surface side of the base housing 231. Also, an acoustic wave of opposite phase, which is output from a rear side of the speaker unit 234, is radiated to the outside from an upper end portion side of the pipe 232 through the opening portion 235 and the pipe 232. In this case, the pipe 232 functions as a resonance tube.

Note that damping materials 246 made of, for example, a rubber material are placed between the end surface on the lower end portion side of the pipe 232 and the base housing 231. This ensures that the closeness can be improved so as to allow, while blocking vibrations caused by the magnetostrictive actuators 100 from propagating to the base housing 231 through the pipe 232, the pipe 232 to satisfactorily function as a resonance tube.

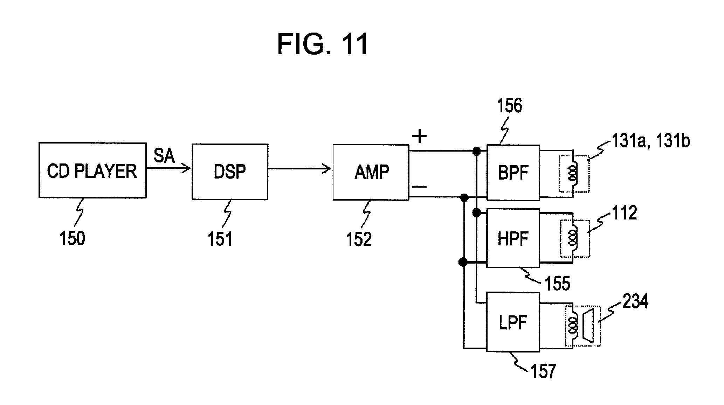

Fig. 11 shows a structure of a drive system for the four hybrid actuators 100A and the speaker unit 234. In Fig. 11, units corresponding to those shown in Fig. 3 are shown with the same numerals.

An audio signal SA from, for example, a CD player 150 serving as a music signal source is supplied to a DSP (Digital Signal Processor) 151, and hybrid actuator correction, that is, correction processing regarding output characteristics of the magnetostrictive actuators 110 and moving-coil actuators 130, correction processing regarding output characteristics of the speaker unit 234, etc., are performed.

The audio signal SA after being subjected to the correction processing by the DSP 151 is amplified by an amplifier 152. Then, a high-frequency-range component of a signal current obtained by the amplification in the amplifier 152 (a current in response to a high-frequency audio signal), for example, a frequency component of 2 kHz to 20 kHz, is extracted by a high-pass filter (HPF) 155, and is supplied to the magnetic field generating coils 112 of the magnetostrictive actuators 110.

A middle-frequency-range component of the signal current obtained by the amplification in the amplifier 152 (a current in response to a middle-frequency-range audio signal), for example, a frequency component of 350 Hz to 2 kHz, is further extracted by a band-pass filter (BPF) 156, and is supplied to the voice coils 131a and 131b of the moving-coil actuators 130. A low-frequency component of the signal current obtained by the amplification in the amplifier 152 (a current in response to a low-frequency-range audio signal), for example, a frequency component of 350 Hz or less, is further extracted by a low-pass filter (LPF) 157, and is supplied to a coil of the speaker unit 234.

In the drive system shown in Fig. 11, only one magnetic field generating coil 112 constituting the magnetostrictive actuators 110 is shown. However, since the speaker apparatus 200C shown in Figs. 6 to 9 uses four hybrid actuators 100A, four magnetic field generating coils 112 are present in actuality. And the current in response to the high-frequency-range audio signal extracted by the high-pass filter 155 is supplied in parallel to those four magnetic field generating coils 112.

Likewise, in the drive system shown in Fig. 11, while only one set of voice coils 131a and 131b constituting the moving-coil actuators 130 is shown, the speaker apparatus 200C shown in Figs. 6 to 9 uses four hybrid actuators 100A and four sets of voice coils 131a and 131b are present in actuality. And the current in response to the middle-frequency-range audio signal extracted by the band-pass filter 156 is supplied in parallel to those four sets of voice coils 131a and 131b.

The operation of the speaker apparatus 200C shown in Figs. 6 to 9 will be described.

The four hybrid actuators 100A fixedly received in the base housing 231 are each constituted by, as described above, the magnetostrictive actuator 110 and the moving-coil actuator 130. As described above, in a case where the magnetostrictive actuators 110 are driven by a high-frequency-range audio signal and the moving-coil actuators 130 are driven by a middle-frequency-range audio signal, a displacement output in response to the high-frequency-range audio signal and a displacement output in response to the middle-frequency-range audio signal are obtained at the tips of the drive rods 113 of the magnetostrictive actuators 110. Due to a displacement of the drive rods 113, the pipe 232 is excited to vibrate with, from the end surface on the lower end portion side thereof, a vibration component in a direction (surface direction) perpendicular to the end surface thereof.

In this case, the end surface on the lower end portion side of the pipe 232 is excited by a longitudinal wave, and an elastic wave (vibration) propagates along the pipe 232 in the surface direction. As this elastic wave propagates along the pipe 232, a mode conversion from a longitudinal wave to a transverse wave to a longitudinal wave ... is repeated to generate a combined longitudinal-transverse wave, and vibrations in a surface-normal direction (a direction vertical with respect to the surface) of the pipe 232 are excited by the transverse waves. Thereby, an acoustic wave is radiated from the pipe 232. That is, an audio output in a high-frequency range, which corresponds to the high-frequency-range audio signal and the middle-frequency-range audio signal, is obtained from the outer surface of the pipe 232.

Furthermore, the speaker unit 234 attached to the lower surface side of the base housing 231 is driven by a low-frequency-range audio signal. A low-frequency-range audio output (positive phase) is obtained from the front side of the speaker unit 234, and this audio output is radiated to the outside from the lower surface side of the base housing 231. A low-frequency-range audio output (opposite phase) is further obtained from the rear side of the speaker unit 234, and this audio output is radiated to the outside from the upper end portion side of the pipe 232 through the opening portion 235 and the pipe 232.

In the speaker apparatus 200C shown in Figs. 6 to 9, the hybrid actuators 100A driven by a high- and middle-frequency-range audio signals are adapted to excite the pipe 232 to vibrate with, from an end surface on the lower end portion side thereof, a vibration component in a direction (surface direction) perpendicular to this end surface. Thus, a large transverse wave is not generated at a vibration excitation point, and an acoustic wave from this vibration excitation point is not perceived as a significantly large sound compared with acoustic waves radiated from other positions, which facilitates the localization of sound across the entirety of the longitudinal direction of the pipe 232. An expanding sound image is obtained.

According to the speaker apparatus 200C shown in Figs. 6 to 9, furthermore, a low-frequency-range audio output (positive phase) obtained from the front side of the speaker unit 234 attached to the lower surface side of the base housing 231 is radiated to the outside from the lower surface side of the base housing 231, and a low-frequency-range audio output (opposite phase) obtained from the rear side of the speaker unit 234 is radiated to the outside from the upper end portion side of the pipe 232 through the opening portion 235 and the pipe 232. This allows perception of uniform sound pressure, also for a low-frequency-range audio output, at individual positions in the longitudinal direction of the pipe 232, which facilitates the localization of sound across the entirety of the longitudinal direction of the pipe 232. An expanding sound image is therefore obtained.

According to the hybrid actuator 100A shown in Fig. 1, as described above, a displacement output caused by the magnetostrictive actuator 110 and a displacement output by the moving-coil actuator 130 are obtained so as to be superimposed on each other at the tip (single drive point) of the drive rod 113 constituting the magnetostrictive actuator 110. Therefore, by abutting the tip of the drive rod 113 against an acoustic diaphragm, the acoustic diaphragm is vibrated by the displacement outputs caused by both actuators 110 and 130. By driving the magnetostrictive actuator 110 by an audio signal in a first frequency band and driving the moving-coil actuator 130 by an audio signal in a second frequency band lower than the first frequency band, a wide band audio output can be obtained (see the speaker apparatuses shown in Figs. 4, 5, and 6).

According to the hybrid actuator 100A shown in Fig. 1, furthermore, as described above, the displacement outputs caused by both the magnetostrictive actuator 110 and the moving-coil actuator 130 can be transmitted to an acoustic diaphragm from the tip (single drive point) of the drive rod 113 of the magnetostrictive actuator 110, and a more coherent audio output than that obtained in the case of transmission of both displacement outputs to the acoustic diaphragm from different drive points can be obtained.

According to the hybrid actuator 100A shown in Fig. 1, moreover, since the magnetostrictive actuator 110 is configured to be coaxially fixed to the movable portion 132 of the moving-coil actuator 130, a reduced low-range resonant frequency compared with that of the moving-coil actuator 130 alone is obtained, which is excellent for low-frequency-range reproduction. A curve b of Fig. 12 shows an acceleration output response of the moving-coil actuator 130, and a low-range resonant frequency f0 is obtained. A curve c of Fig. 12, on the other hand, shows an acceleration output response of the hybrid actuator 100A, and a low-range resonant frequency f0' is obtained, which is found to be lower than f0 described above. Such a reduction in the low-range resonant frequency in the hybrid actuator 100A is because the mass of the magnetostrictive actuator 110 is added to that of the movable portion 132 of the moving-coil actuator 130.

Note that, as can be seen from the acceleration output response of the hybrid actuator 100A shown by the curve c of Fig. 12, in the hybrid actuator 100A, insufficient sound pressure (acceleration) in the low-frequency range of the magnetostrictive actuator 110 is overcome by the moving-coil actuator 130. A curve a of Fig. 12 shows an acceleration output response of the magnetostrictive actuator 110.

Note that while the speaker apparatuses 200A, 200B, and 200C shown in Figs. 4, 5, and 6 are such that the tip of the drive rod 113 of the magnetostrictive actuator 110 is directly abutted against an acoustic diaphragm (the planar diaphragm 210 or the pipe 232 serving as a tubular diaphragm), the tip of the drive rod 113 may be indirectly abutted against the acoustic diaphragm.

For example, an insertion plate having a larger area than that of a surface of the tip of the drive rod 113 can be interposed between the tip of the drive rod 113 and an acoustic diaphragm. For example, in a case where a pipe (tubular diaphragm) is used as an acoustic diaphragm, it is contemplated that a circular-plate-shaped insertion plate is abutted so as to be brought into abutment against the entirety of a lower end surface of the pipe and that the tip of the drive rod 113 is brought into abutment against a lower end surface of this insertion plate.

For example, furthermore, an insertion plate of various materials can be interposed between the tip of the drive rod 113 and an acoustic diaphragm. In this case, examples of the available materials of the insertion plate include wood, aluminum, glass, etc. Due to different unique vibration modes depending on the materials, different timbres can be obtained depending on the materials.

Next, another embodiment of the present invention will be described. A cross-sectional view shown in Fig. 13 shows a structure of a hybrid actuator 100B as another embodiment. The hybrid actuator 100B includes a magnetostrictive actuator 160 constituting a magnetostrictive actuator unit, and a moving-coil actuator 165.

The hybrid actuator 100B includes a circular-tube-shaped magnetostrictive element 171 that expands and contracts in a longitudinal direction, a magnetic field generating coil (solenoid coil) 172 that is arranged inside the magnetostrictive element 171 and that generates a magnetic field in an expansion and contraction direction of the magnetostrictive element 171, a cylindrical pole piece 173 with iron properties that is arranged inside the magnetic field generating coil 172, circular-plate-shaped iron yokes 174a and 174b fixedly arranged at either end of the pole piece 173, and ring-shaped iron yokes 175a and 175b fixedly arranged at either end of the magnetostrictive element 171. The magnetostrictive element 171 and the magnetic field generating coil 172 constitute the magnetostrictive actuator 160.

The ring-shaped yoke 175b is arranged so that the circular-plate-shaped yoke 174b is located inside it. A damper 176b is installed between those yokes 175b and 174b, and the yoke 175b is fixed to the yoke 174b in a displaceable manner. Likewise, the ring-shaped yoke 175a is made up of a small-diameter portion on a tip side, and a large-diameter portion joined with the small-diameter portion. The ring-shaped yoke 175a is arranged so that the circular-plate-shaped yoke 174a is located inside the large-diameter portion. A damper 176a is installed between those yokes 175a and 174a, and the yoke 175a is fixed to the yoke 174a in a displaceable manner.

The yokes 175a and 175b constitute a movable portion of the moving-coil actuator 165. As described above, since those yokes 175a and 175b are fixedly arranged at either end of the magnetostrictive element 171, as a consequence, the magnetostrictive actuator 160 is coaxially fixed to the movable portion of the moving-coil actuator 165.

The yoke 175a further constitutes a drive rod of the magnetostrictive actuator 160, and constitutes a single drive point for transmitting a displacement output in the hybrid actuator 100B to an acoustic diaphragm. For example, an aluminum circular plate member 177, which constitutes a drive surface, is bonded and fixed to a tip surface on a small-diameter side of this yoke 175a. Here, the circular plate member 177 constitutes a displacement transmitting unit that outputs a displacement caused by expansion and contraction of the magnetostrictive element 111.

The hybrid actuator 100B further includes voice coils 178a and 178b, an aluminum fixing board 179, a ring-shaped magnet (permanent magnet) 180, and tube-shaped yokes 181 with iron properties. The voice coils 178a and 178b are attached, respectively, to outer peripheries of the ring-shaped yokes 175a and 175b constituting the movable portion of the moving-coil actuator 165. Note that those voice coils 178a and 178b are designed to have opposite winding directions because magnetic flux directions at their respective positions are opposite to each other so that Lorentz forces generated at the voice coils 178a and 178b are caused to be in the same direction.

The fixing board 179 has a cylindrical convex portion disposed at a center thereof, and the yoke 174b described above is bonded and fixed onto the convex portion. On the fixing board 179, the single ring-shaped magnet 180 and the two tube-shaped yokes 181 are alternately stacked and fixed so as to be located around the magnetostrictive element 171 and the magnetic field generating coil 172. Here, the two tube-shaped yokes 181 located on either side of the ring-shaped magnet 180 are each provided with a projecting portion that projects at right angle to a side opposite to the magnet 180 side, and the projecting portions are in a state of facing the voice coils 178a and 178b.

Here, the ring-shaped magnet 180 and the tube-shaped yokes 181 constitute, together with the ring-shaped yokes 175a and 175b and magnetostrictive element 171 described above, a magnetic circuit (first magnetic circuit). In this case, the magnetostrictive element 171 is in a state of being inserted in a magnetic flux path in this magnetic circuit. This magnetic circuit is provided in order to apply a magnetic bias (static bias) to the magnetostrictive element 171. The application of magnetic bias allows the magnetostrictive element to be expanded to some extent in advance, and enables not only expansion but also contraction in a magnetic field generated in the magnetic field generating coil 172.

The ring-shaped magnet 180 and the tube-shaped yokes 181 also constitute, together with the ring-shaped yokes 175a and 175b, circular-plate-shaped yokes 174a and 174b, and pole piece 173 described above, a magnetic circuit (second magnetic circuit). This magnetic circuit generates interlinked magnetic fluxes in the voice coils 178a and 178b. Since the magnetic flux path of this second magnetic circuit does not have the magnetostrictive element 171 inserted therein, the magnetostrictive element 171, which is low in magnetic permeability, would not adversely affect the displacement operation of the moving-coil actuator 165.

The hybrid actuator 100B is configured in the manner described above. A current in response to a high-frequency-range audio signal (high-frequency-range component of an audio signal) is caused to flow in the magnetic field generating coil 172 constituting the magnetostrictive actuator 160 to generate a magnetic field in the expansion and contraction direction of the magnetostrictive element 171, thereby allowing the magnetostrictive element 171 to be expanded and contracted according to the high-frequency-range audio signal. At one end thereof, that is, at a tip (drive surface) of the ring-shaped yoke (drive rod) 175a, a displacement output in accordance with the high-frequency-range audio signal is obtained.

A current in response to a low-frequency-range audio signal (low-frequency component of the audio signal) is further caused to flow in the voice coils 178a and 178b constituting the moving-coil actuator 165, thereby allowing the ring-shaped yokes 175a and 175b serving as the movable portion to be displaced by the Lorentz force in an axial direction (which is the same as the expansion and contraction direction of the magnetostrictive element 171 of the magnetostrictive actuator 160) according to the low-frequency-range audio signal.

As described above, a structure is provided in which the ring-shaped yokes 175a and 175b are bonded and fixed to either end of the magnetostrictive element 171 and in which the magnetostrictive actuator 160 is coaxially fixed to the movable portion of the moving-coil actuator 165. Thus, the displacement of the yokes 175a and 175b serving as the movable portion of the moving-coil actuator 165 in the axial direction is also transmitted to the magnetostrictive element 171 of the magnetostrictive actuator 160 described above. Thus, at the one end of the magnetostrictive element 171, that is, at the tip (drive surface) of the ring-shaped yoke (drive rod) 175a, in addition to the displacement output in response to the high-frequency-range audio signal, which is generated by the magnetostrictive actuator 160 itself described above, a displacement output in response to the low-frequency-range audio signal, which is generated by the moving-coil actuator 165, is also obtained in such a manner as to be superimposed thereon.

According to the hybrid actuator 100B shown in Fig. 13, at the tip (single drive point) of the ring-shaped yoke (drive rod) 175a, as described above, a displacement output caused by the magnetostrictive actuator 160 and a displacement output caused by the moving-coil actuator 165 are obtained so as to be superimposed on each other. Therefore, by abutting the tip of the ring-shaped yoke 175a against an acoustic diaphragm, this acoustic diaphragm is vibrated by the displacement outputs caused by both actuators 160 and 165. By driving the magnetostrictive actuator 160 by an audio signal in a first frequency band and driving the moving-coil actuator 165 by an audio signal in a second frequency band lower than the first frequency band, a wide band audio output can be obtained (see the speaker apparatuses shown in Figs. 4, 5, and 6).

According to the hybrid actuator 100B shown in Fig. 13, furthermore, as described above, the displacement outputs caused by both the magnetostrictive actuator 160 and the moving-coil actuator 165 can be transmitted to an acoustic diaphragm from the tip (single drive point) of the ring-shaped yoke (drive rod) 175a, and a more coherent audio output than that obtained in the case of transmission of both displacement outputs to the acoustic diaphragm from different drive points can be obtained.

According to the hybrid actuator 100B shown in Fig. 13, moreover, since the magnetostrictive actuator 160 is configured to be coaxially fixed to the movable portion of the moving-coil actuator 165, a reduced low-range resonant frequency compared with that of the moving-coil actuator 165 alone is obtained, which is excellent for low-frequency-range reproduction (see Fig. 12).

Further, according to the hybrid actuator 100B shown in Fig. 13, the first magnetic circuit for applying a magnetic bias to the magnetostrictive element 171 and the second magnetic circuit for obtaining interlinked magnetic fluxes in the voice coils 178a and 178b are shared at a portion corresponding to the ring-shaped magnet 180 and the tube-shaped yokes 181, which contributes to lightweight and compact design. In addition, the sharing of the magnet 180 allows for low-cost construction.

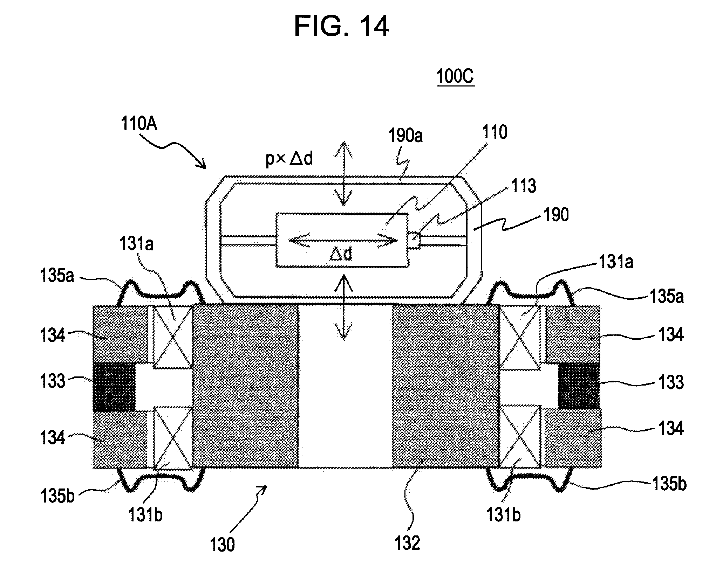

Next, still another embodiment of the present invention will be described. Fig. 14 shows a structure of a hybrid actuator 100C as another embodiment. In Fig. 14, units corresponding to those shown in Fig. 1 are shown with the same numerals, the detailed description of which is omitted.

The hybrid actuator 100C is configured such that a magnetostrictive actuator unit 110A is fixed to a movable portion 132 of a moving-coil actuator 130. Furthermore, the magnetostrictive actuator unit 110A is configured such that a magnetostrictive actuator 110 (see Fig. 1) is attached to a displacement magnifying device 190.

The displacement magnifying device 190 is formed using, for example, a spring material, for example, phosphor bronze. In this case, a displacement Δd of a drive rod 113 appears as a displacement p (> 1) times the original in the displacement transmitting unit 190a of the displacement magnifying device 190, which is a unit extending in a direction perpendicular to an axial direction of the drive rod 113.

Also in the hybrid actuator 100C, the magnetostrictive actuator unit 110A is designed to be fixed to the movable portion 132 of the moving-coil actuator 130 so that the direction of displacement output of the displacement transmitting unit 190a becomes the same as the displacement direction of the movable portion 132, and advantages similar to those of the hybrid actuator 100A shown in Fig. 1 can be achieved.

### Industrial Applicability

The present invention is intended to provide the capability of satisfactorily obtaining a wide band audio output, and can be applied to a speaker apparatus, etc., in an audio-visual apparatus.

## Claims

1. A hybrid actuator **characterized by** comprising:
a magnetostrictive actuator unit including a magnetostrictive element, a first magnetic circuit that has a magnet and that applies a magnetic bias to the magnetostrictive element, and a magnetic field generating coil that generates a magnetic field in an expansion and contraction direction of the magnetostrictive element, and also including a displacement transmitting unit that outputs a displacement caused by expansion and contraction of the magnetostrictive element; and
a moving-coil actuator including a movable portion to which voice coils are attached, and a second magnetic circuit that has a magnet and that generates interlinked magnetic fluxes in the voice coils,
wherein the magnetostrictive actuator unit is fixed to the movable portion of the moving-coil actuator so that a direction of displacement output of the displacement transmitting unit becomes the same as a displacement direction of the movable portion.

2. The hybrid actuator according to Claim 1, **characterized in that** the magnetostrictive actuator unit is driven by an audio signal in a first frequency band, and the moving-coil actuator is driven by an audio signal in a second frequency band that is on a side lower than the first frequency band.

3. The hybrid actuator according to Claim 1, **characterized in that** the magnetostrictive actuator unit further includes a displacement magnifying device that magnifies the displacement caused by expansion and contraction of the magnetostrictive element and that transmits the displacement to the displacement transmitting unit.

4. The hybrid actuator according to Claim 1, **characterized in that** magnetic flux paths in the first magnetic circuit of the magnetostrictive actuator unit and the second magnetic circuit of the moving-coil actuator are partially shared, and
the magnetostrictive element constitutes the magnetic flux path in the first magnetic circuit and does not constitute the magnetic flux path in the second magnetic circuit.

5. A speaker apparatus **characterized by** comprising:
an acoustic diaphragm; and
a hybrid actuator including a displacement transmitting unit for transmitting a displacement output to the acoustic diaphragm, the displacement transmitting unit being placed so as to be brought into direct or indirect abutment against the acoustic diaphragm, the hybrid actuator being driven based on an audio signal,
wherein the hybrid actuator includes
a magnetostrictive actuator unit including a magnetostrictive element, a first magnetic circuit that has a magnet and that applies a magnetic bias to the magnetostrictive element, and a magnetic field generating coil that generates a magnetic field in an expansion and contraction direction of the magnetostrictive element, and also including the displacement transmitting unit that outputs a displacement caused by expansion and contraction of the magnetostrictive element, and
a moving-coil actuator including a movable portion to which voice coils are attached, and a second magnetic circuit that has a magnet and that generates interlinked magnetic fluxes in the voice coils,
the magnetostrictive actuator unit being fixed to the movable portion of the moving-coil actuator so that a direction of displacement output of the displacement transmitting unit becomes the same as a displacement direction of the movable portion.

6. The speaker apparatus according to Claim 5, **characterized in that** the acoustic diaphragm is a planar diaphragm, and
the displacement transmitting unit of the hybrid actuator is abutted against a surface of the planar diaphragm.

7. The speaker apparatus according to Claim 5, **characterized in that** the acoustic diaphragm is a tubular diaphragm, and
the displacement transmitting unit of the hybrid actuator is abutted against an end surface of the tubular diaphragm.

8. An audio output method **characterized by** comprising:
using a hybrid actuator including a magnetostrictive actuator unit including a magnetostrictive element, a first magnetic circuit that has a magnet and that applies a magnetic bias to the magnetostrictive element, and a magnetic field generating coil that generates a magnetic field in an expansion and contraction direction of the magnetostrictive element, and also including a displacement transmitting unit that outputs a displacement caused by expansion and contraction of the magnetostrictive element, and a moving-coil actuator including a movable portion to which voice coils are attached, and a second magnetic circuit that has a magnet and that generates interlinked magnetic fluxes in the voice coils, wherein the magnetostrictive actuator unit is fixed to the movable portion of the moving-coil actuator so that a direction of displacement output of the displacement transmitting unit becomes the same as a displacement direction of the movable portion;
abutting the displacement transmitting unit of the hybrid actuator directly or indirectly against an acoustic diaphragm; and
driving the magnetostrictive actuator unit by an audio signal in a first frequency band and driving the moving-coil actuator by an audio signal in a second frequency band that is on a side lower than the first frequency band.
